# EUROPEAN PATENT APPLICATION

(11) **EP 4 657 081 A1**
(43) Date of publication of application: **03.12.2025**
(21) Application number: 23918522.6
(22) Date of filing: 08.11.2023
(51) Int. Cl.: G01R 15/20

(54) **ELECTRIC CURRENT SENSOR**

(30) Priority: 25.01.2023 JP 2023009438
(71) Applicant: Alps Alpine Co., Ltd., Tokyo 145-8501 (JP)
(72) Inventor: CHIBA, Ken, Tokyo 145-8501 (JP); TAMURA, Manabu, Tokyo 145-8501 (JP)
(74) Representative: Maiwald GmbH
(86) International application number: PCT/JP2023/040148
(87) International publication number: WO 2024/157567

(57) **Abstract**

A current sensor 10, which has a bus bar effective in achieving a low cost and weight reduction, according to the present invention has a bus bar 1 in which a current under measurement flows as well as a magnetic detection unit 2 placed so as to face the bus bar 1, the magnetic detection unit 2 sensing a magnetic field generated around the bus bar 1. The bus bar 1 is formed from a laminate material in which a first metal material 3 and a second metal material 4, which are different types of metal materials, are laminated. The density of the first metal material 3 is larger than that of the second metal material 4. The electrical resistivity of the first metal material 3 is smaller than that of the second metal material 4. The magnetic detection unit 2 is placed so as to face a surface 3S of the bus bar 1, the surface 3S being formed from the first metal material 3.

## Description

### Technical Field

The present invention relates to a current sensor that detects a magnetic field generated by a current under measurement that flows in a bus bar and that measures the current value of a measured current from the detected magnetic field.

### Background Art

Recently, to control and monitor any of various units, a current sensor is used that is attached to the unit and measures a current under measurement that flows in the unit. As a current sensor of this type, a current sensor is known that uses a magneto-electric conversion element that senses a magnetic field generated due to a flow of a current under measurement in a bus bar used as a current path. Also, requirements for current sensors such as for weight reduction and cost reduction to improve electricity consumption are becoming more sophisticated and more advanced in correspondence to an increase in electric cars and hybrid vehicles, which use a motor as a power source.

In a current sensor, intended for improving pulse response, that uses bus bars, shield plates, magnetic detection elements, and a conductive plate, the use of a plate-like superior electrical conductor, which is formed from copper, aluminum, or the like, as the bus bar is described in PTL 1.

### Citation List

### Patent Literature

PTL 1: Japanese Unexamined Patent Application Publication No. 2019-109126

### Summary of Invention

### Technical Problem

However, the current sensor described in PTL 1 uses a bus bar machined from a single superior electrical conductor, and a structure of the bus bar to reduce the weight and cost of the current sensor is not described.

Therefore, an object of the present invention is to provide a current sensor having a bus bar effective for reducing its weight and cost.

### Solution to Problem

The present invention has a structure below as a means for solving the problem described above.

In a current sensor having a bus bar in which a current under measurement flows as well as a magnetic detection unit placed so as to face the bus bar, the magnetic detection unit sensing a magnetic field generated around the bus bar, the current sensor is characterized in that: the bus bar is formed from a laminate material in which a first metal material and a second metal material, which are different types of metal materials, are laminated; the density of the first metal material is larger than that of the second metal material, and the electrical resistivity of the first metal material is smaller than that of the second metal material; and the magnetic detection unit is placed so as to face a surface of the bus bar, the surface being formed from the first metal material.

Due to a structure in which two types of metal materials are laminated, a balance can be obtained between reduction in the amount of heat generation in the bus bar when a current under measurement flows and reduction in the weight of the bus bar by adjusting the ratio of metal materials the densities and electrical resistivities of which differ.

In the bus bar, in a lamination direction, a dimension of the second metal material may be larger than a dimension of the first metal material.

In the bus bar, in a lamination direction, a dimension of the second metal material may be 80% or more of a dimension of the lamination material.

In the case in which the magnetic detection unit is placed so as to face a surface of the bus bar, the surface being formed from the first metal material, due to the above structure, it is possible to achieve heat generation suppression by use of the first metal material when a current under measurement flows and weight reduction by use of the second metal material, while the frequency characteristics of the bus bar are kept high.

In a current sensor having a bus bar in which a current under measurement flows as well as a magnetic detection unit placed so as to face the bus bar, the magnetic detection unit sensing a magnetic field generated around the bus bar, the current sensor is characterized in that: the bus bar is formed from a laminate material in which a first metal material and a second metal material, which are different types of metal materials, are laminated; the density of the first metal material is larger than that of the second metal material, and the electrical resistivity of the first metal material is smaller than that of the second metal material; and the magnetic detection unit is placed so as to face a surface of the bus bar, the surface being formed from the second metal material.

Due to a structure in which two types of metal materials are laminated, a balance can be obtained between reduction in the amount of heat generation in the bus bar when a current under measurement flows and reduction of the weight of the bus bar.

In the bus bar, in a lamination direction, a dimension of the second metal material may be larger than a dimension of the first metal material.

In the bus bar, in a lamination direction, a dimension of the second metal material may be 60% or more of a dimension of the lamination material.

In the case in which the magnetic detection unit is placed so as to face a surface of the bus bar, the surface being formed from the second metal material, due to the above structure, it is possible to achieve heat generation suppression by use of the first metal material when a current under measurement flows and weight reduction by use of the second metal material, while the frequency characteristics of the bus bar are kept high.

In a current sensor having a plurality of measurement phases, each of which is composed of a bus bar in which a current under measurement flows, as well as a magnetic detection unit placed so as to face the bus bar, the magnetic detection unit sensing a magnetic field generated around the bus bar, the current sensor is characterized in that: the bus bar is formed from a laminate material in which a first metal material and a second metal material, which are different types of metal materials, are laminated; the density of the first metal material is larger than that of the second metal material, and the electrical resistivity of the first metal material is smaller than that of the second metal material; and a first measurement phase is provided in which the magnetic detection unit is placed so as to face a surface of the bus bar, the surface being formed from the first metal material, and a second measurement phase is provided in which the magnetic detection unit is placed so as to face a surface of the bus bar, the surface being formed from the second metal material.

Since the electrical resistivity of the first metal material is smaller than that of the second metal material, much more current flows in the first metal material. Therefore, by placing the magnetic detection unit so as to face a surface formed from the first metal material, magnetic field density sensed by the magnetic detection unit becomes large, so the sensing precision of the first measurement phase becomes superior to that of the second measurement phase. Therefore, by using a measurement phase for which high precision is demanded as the first measurement phase, a plurality of measurement phases can be placed according to demanded sensing precision.

Second measurement phases may be adjacently placed on both sides of the first measurement phase.

In the case in which three or more measurement phases are provided, measurement error becomes large in a measurement phase that receives influence from measurement phases next to both sides of the measurement phase. Therefore, in the case in which measurement phases are adjacently provided on both sides, by using the second measurement phase as each of the measurement phases on both sides and using the first measurement phase as the measurement phase at the center, it is possible to suppress a drop in the sensing precision of the first measurement phase and to reduce a difference in measurement precision among a plurality of measurement phases.

In the bus bar, in a lamination direction, a dimension of the second metal material may be larger than a dimension of the first metal material.

Due to this structure, a balance can be obtained between weight reduction by use of the second metal material and heat generation suppression by use of the first metal material, while the frequency characteristics of the bus bar are kept high as a result of laminating the first metal material on the second metal material.

In at least one measurement phase, the bus bar may have a bent portion. The magnetic detection unit may be placed at a position at which the magnetic detection unit can sense induced magnetic fields from two portions positioned with the bent portion interposed therebetween in the bus bar.

Due to this structure, the magnetic detection unit can sense induced magnetic fields from two portions positioned with the bent portion interposed therebetween, so the sensing precision of the current sensor is improved.

In the bus bar, the first metal material may be provided on the side on which the bent portion is bent. The magnetic detection unit may face a layer of the first metal material of the bus bar.

By providing the layer formed from the first metal material on the side on which the bent portion is bent, the magnetic flux density of the induced magnetic field sensed by the magnetic detection unit becomes high, so the sensing precision of the current sensor is improved.

The first metal material may be a copper material, and the second metal material may be an aluminum material.

By laminating a copper material, the electrical resistivity of which is low, and an aluminum material, the density of which is small, the bus bar becomes a lightweight bus bar the frequency characteristics of which is superior and in which heat generation is suppressed.

### Advantageous Effects of Invention

According to the present invention, by using a laminate material in which different types of metal materials are laminated, the property of the bus bar can be adjusted, so it becomes possible to provide a current sensor appropriate for downsizing and slimming down.

### Brief Description of Drawings

[Fig. 1A] Fig. 1A is a plan view of a current sensor in a first embodiment.
[Fig. 1B] Fig. 1B is a sectional view of the current sensor as taken along line AA in Fig. 1A.
[Fig. 2] Fig. 2 is a graph indicating simulation results for the ratio of a thickness T4 of Al to a total thickness T1 and for bus bar phase characteristics in the case in which the bus bar in Fig. 1B is formed from Cu and Al.
[Fig. 3] Fig. 3 is a sectional view of the current sensor, in Fig. 1B, in which magnetic shields are provided.
[Fig. 4] Fig. 4 is a sectional view of a current sensor in a second embodiment.
[Fig. 5] Fig. 5 is a graph indicating simulation results for the ratio of the thickness T4 of Al to the total thickness T1 and for bus bar phase characteristics in the case in which the bus bar in Fig. 4 is formed from Cu and Al.
[Fig. 6] Fig. 6 is a sectional view of the current sensor, in Fig. 4, in which magnetic shields are provided.
[Fig. 7A] Fig. 7A is a graph indicating differences in magnetic flux density due to a lamination order and Al ratio in a bus bar in which Al and Cu are laminated.
[Fig. 7B] Fig. 7B is a graph indicating differences in influence on an adjacent bus bar due to a lamination order and Al ratio in a bus bar in which Al and Cu are laminated.
[Fig. 8] Fig. 8 is a sectional view indicating a current sensor of multi-phase type in a third embodiment.
[Fig. 9] Fig. 9 is a perspective view indicating a current sensor of multi-phase type in a variation.
[Fig. 10] Fig. 10 is a perspective view indicating a current sensor of multi-phase type in another variation.
[Fig. 11A] Fig. 11A is a plan view of a current sensor in a reference example.
[Fig. 11B] Fig. 11B is a sectional view of the current sensor as taken along line BB in Fig. 11A.
[Fig. 12A] Fig. 12A is a graph indicating the relationship between the frequency and phase angle of a current flowing in the bus bar in the reference example in Fig. 11A.
[Fig. 12B] Fig. 12B is a graph indicating the relationship between the frequency and gain of a current flowing in the bus bar in the reference example in Fig. 11A.
[Fig. 13A] Fig. 13A is a graph indicating temperature changes accompanying the elapse of time when a current under measurement is caused to flow, in a conventional bus bar, in which a tightening portion is formed from Al and a main body is formed from Al.
[Fig. 13B] Fig. 13B is a graph indicating temperature changes accompanying the elapse of time when a current under measurement is caused to flow, in the conventional bus bar, in which the tightening portion is formed from Cu and the main body is formed from Cu.
[Fig. 13C] Fig. 13C is a graph indicating temperature changes accompanying the elapse of time when a current under measurement is caused to flow in the bus bar, in the reference example, in which the tightening portion is formed from Cu and the main body is formed from Al.
[Fig. 14A] Fig. 14A is a plan view of a current sensor in another reference example.
[Fig. 14B] Fig. 14B is a sectional view of the current sensor as taken along line BB in Fig. 14A.
[Fig. 15A] Fig. 15A is a plan view of a conventional current sensor.
[Fig. 15B] Fig. 15B is a sectional view of the current sensor as taken along line AA in Fig. 15A.
[Fig. 15C] Fig. 15C is a sectional view of the current sensor as taken along line BB in Fig. 15A.

### Description of Embodiments

Embodiments of the present invention will be described below with reference to the attached drawings. Identical members are assigned identical numerals on each drawing, and descriptions will be omitted. Reference coordinates are appropriately indicated on each drawing to indicate the positional relationship of each member. In the reference coordinates, the direction in which the bus bar extends is the X direction; the direction orthogonal to the X direction on the facing surface of the bus bar, the facing surface facing a magnetic detection unit, is the Y direction; and the direction orthogonal to the X direction and Y direction is the Z direction. The Y direction is the direction of the sensitivity axis of the magnetic detection unit. The X direction and Z direction are orthogonal to the sensitivity axis.

### [First embodiment]

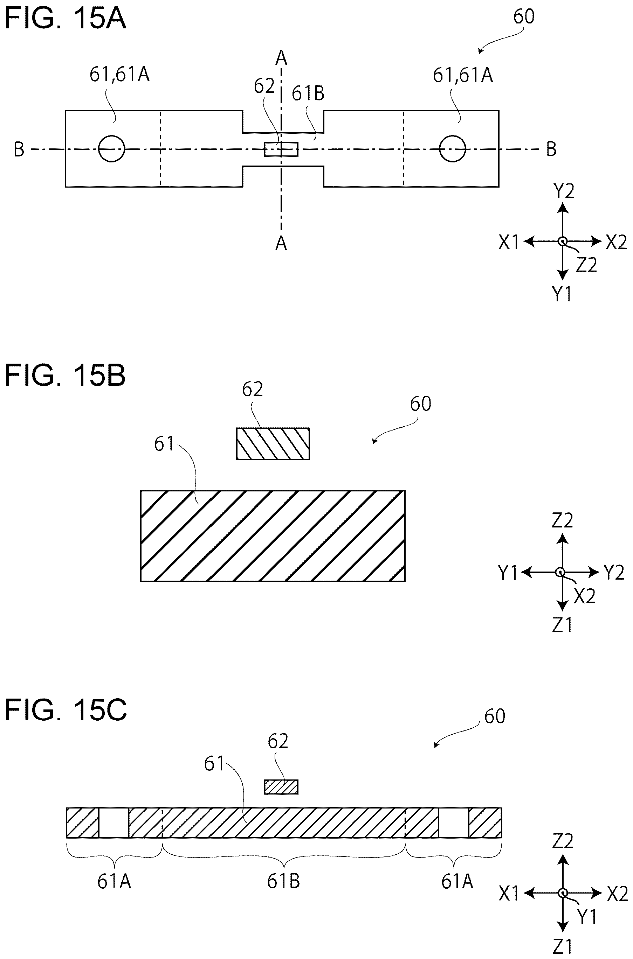

Fig. 15A is a plan view of a conventional current sensor 60. Fig. 15B is a sectional view of the current sensor 60 as taken along line AA in Fig. 15A. As indicated in these drawings, with the conventional current sensor 60, which has a bus bar 61 and a magnetic detection unit 62, a plate-like electrical conductor is used as the bus bar 61, in which a current under measurement flows. Materials of the electrical conductor include copper and aluminum. Copper, which is superior in conductivity, is often used alone. However, in the case in which the bus bar 61 is formed from only copper, correspondence to more sophisticated and more advanced requirements for current sensors, such as for weight reduction and cost reduction, may be difficult. To achieve downsizing and slimming down of the current sensor, therefore, the present invention uses a bus bar formed from a laminate material in which different types of metal materials are laminated.

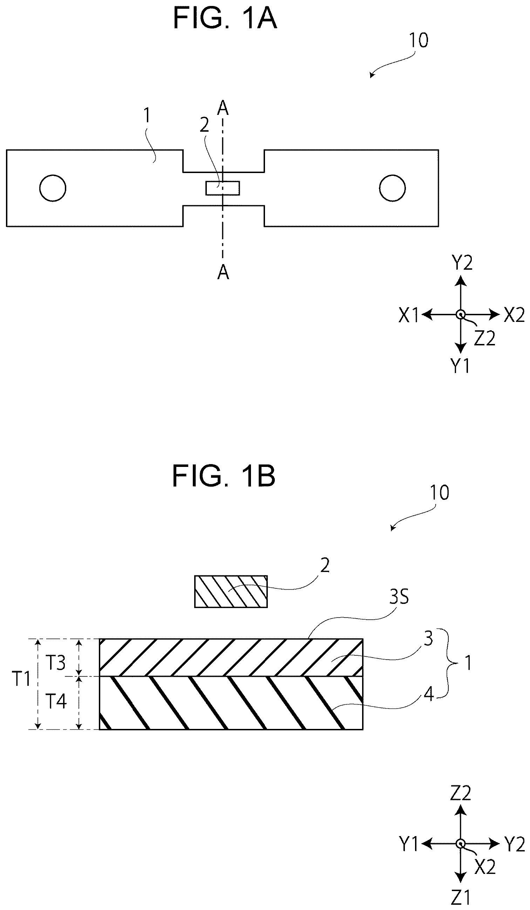

Fig. 1A and Fig. 1B are a plan view of a current sensor 10 in this embodiment and a sectional view of the current sensor 10 as taken along line AA in Fig. 1A. As indicated in these drawings, the current sensor 10 has a bus bar 1, in which a current under measurement flows, as well as a magnetic detection unit 2 placed so as to face the bus bar 1, the magnetic detection unit 2 sensing a magnetic field generated around the bus bar 1.

The bus bar 1 is formed from a laminate material in which a first metal material 3 and a second metal material 4, which are different types of metal materials, are laminated. With the bus bar 1 in this embodiment, each of the first metal material 3 and second metal material 4 is structured as a layer the Z-direction thickness of which is uniform.

The density of the first metal material 3 is larger than that of the second metal material 4 (in other words, the first metal material 3 is heavier than the second metal material 4), and the electrical resistivity (appropriately referred to below as resistivity) of the first metal material 3 is smaller than that of the second metal material 4.

The magnetic detection unit 2 in the current sensor 10 is placed so as to face a surface 3S of the bus bar 1, the surface 3S being formed from the first metal material 3.

A copper material, for example, can be used as the first metal material 3, and an aluminum material can be used as the second metal material 4. Copper materials refer to pure copper, copper alloys, and conductive materials including pure copper and copper alloys. Aluminum materials refer to pure aluminum, aluminum alloys, and conductive materials including pure aluminum and aluminum alloys.

A case in which Cu (pure copper) is used as a copper material and Al (pure aluminum) is used as an aluminum material will be described below as an example. Since the specific gravity and density of Al are smaller than those of Cu and the cost of Al is lower than that of Cu, a bus bar formed from Al is more advantageous than a bus bar formed from Cu in terms of weight reduction and cost reduction.

However, since the resistivity of Al is 2.65 × 10⁻⁸ [Ω·m], which is larger than the resistivity of Cu, 1.68 × 10⁻⁸ [Ω·m], if the material of the bus bar is Al, the resistivity of the bus bar becomes large. Therefore, the temperature of the magnetic detection unit 2 rises due to the influence of heat generation in the bus bar when a current under measurement flows. This may cause the problem that if the heat-resistant temperature of the magnetic detection unit 2 is exceeded, the detection precision of the current sensor 10 is lowered.

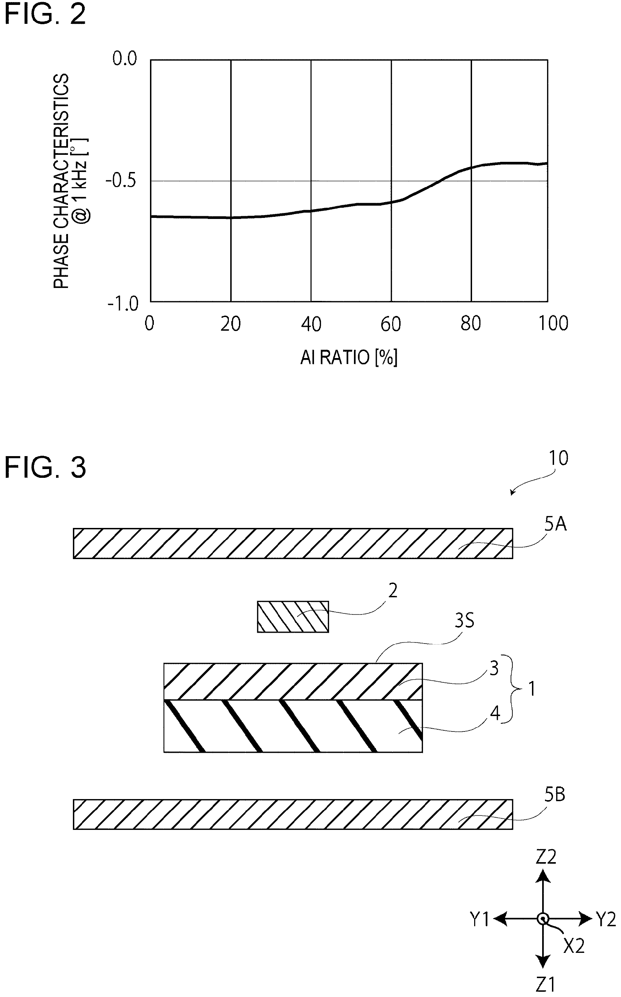

Fig. 2 is a graph indicating results of a simulation performed so that a thickness T3 of Cu and a thickness T4 of Al in the Z direction were changed in the case in which Cu was used as the first metal material 3 and Al was used as the second metal material 4 for the bus bar 1, indicated in Fig. 1B, formed from a laminate material. The horizontal axis in the drawing indicates the ratio, T4/T1 × 100 (%), of the thickness T4 of Al to the total, T1 = T3 + T4, of the thicknesses of Cu and Al.

The bus bar 1, for which the simulation in Fig. 2 was performed, has a laminate structure indicated in Fig. 1B. A Cu layer is placed as the first metal material 3 on the Z2 side, which is on the same side as the magnetic detection unit 2. An Al layer is placed as the second metal material 4 on the Z1 side, which is the opposite side of the magnetic detection unit 2.

In the graph in Fig. 2, the state when the phase characteristics on the vertical axis is 0.0°is an ideal state, in which there is no delay of an output voltage from the current sensor 10 with respect to the current under measurement. The graph indicates that the lower (the more toward -1.0°) the vertical axis is, the greater the delay of the output voltage is. When this delay is great, a time delay of the output voltage from the current sensor 10 with respect to the current under measurement becomes large in a high-frequency band. Therefore, it can be said that the phase characteristics on the vertical axis are preferably closer to 0.0°. In this graph, it is indicated that the delay of the output voltage from the current sensor 10 is the smallest in the case in which the bus bar 1 with an Al ratio of 100% is provided and that there is an inflection point of the phase characteristics at an Al ratio from 60% to 80%.

It can be said from the results indicated in Fig. 2 that the thickness T4, which is a dimension of the second metal material 4 in the Z direction, which is the lamination direction, is preferably larger than the thickness T3, which is a dimension of the first metal material 3, from the viewpoint of suppressing deterioration in the frequency characteristics of the bus bar 1, the deterioration being related to the delay of the output voltage from the current sensor 10, and achieving weight reduction. Also, in the case in which the thickness T1 (= T3 + T4), which is a dimension of the bus bar 1, formed from a laminate material, in the lamination direction is 100%, the thickness T4 of the second metal material 4 is more preferably 80% or more.

Fig. 3 is a sectional view of the current sensor 10 in which magnetic shields 5A and 5B are provided. As indicated in the drawing, in the current sensor 10, the magnetic shields 5A and 5B may be provided on both sides in the Z direction so that the bus bar 1 and magnetic detection unit 2 are interposed therebetween. Due to the magnetic shields 5A and 5B, it is possible to suppress magnetic noise from the outside into the magnetic detection unit 2, so the measurement precision of the current sensor 10 is improved. Incidentally, a structure may be taken in which a magnetic shield is provided only on the Z1 side of the bus bar 1 or only on the Z2 side of the magnetic detection unit 2 (a structure may be taken in which any one of the magnetic shields 5A and 5B is provided).

As the magnetic shields 5A and 5B, a stack of a plurality of metal plate-like bodies having the same shape is used, for example. In each drawing used for explanation, a stack of a plurality of plate-like bodies is simplified to one plate-like body to illustrate the magnetic shield 5A or 5B.

A magnetic shield of U-shaped type, which has a U-shaped cross section along line AA in Fig. 1A, may be used instead of the magnetic shield 5A or 5B of flat-plate type indicated in Fig. 3. More specifically, a magnetic shield of U-shaped type may be used that encloses the magnetic detection unit 2 by having the bus bar 1 take a U shape formed on both sides of the bus bar 1 in the Y direction and on its Z1-direction side.

### [Second embodiment]

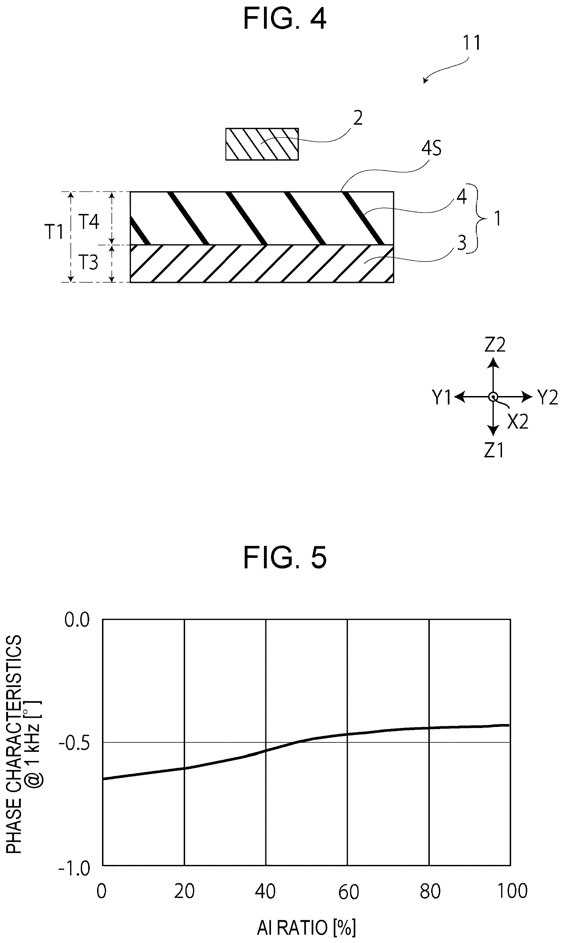

Fig. 4 is a sectional view of a current sensor 11 in this embodiment.

The current sensor 11 in this embodiment is the same as before in that the laminate material forming the bus bar 1 is a stack of the first metal material 3 and second metal material 4. However, the current sensor 11 differs from the current sensor 10, in which the magnetic detection unit 2 is placed so as to face the surface 3S of the bus bar 1, the surface 3S being formed from the first metal material 3, in that the magnetic detection unit 2 is placed so as to face a surface 4S of the bus bar 1, the surface 4S being formed from the second metal material 4.

Fig. 5 is a graph indicating results of a simulation performed so that the thickness T3 of Cu and the thickness T4 of Al in the Z direction are changed in the case in which a laminate material in which the first metal material 3 is Cu and the second metal material 4 is Al is used as the bus bar 1 indicated in Fig. 4. The horizontal axis in the drawing indicates the ratio of the thickness T4 of Al to the thickness T1 of the bus bar 1.

The bus bar 1 for which a simulation, results of which are indicated in Fig. 5, was performed has the laminate structure indicated in Fig. 4; an Al layer is placed as the second metal material 4 on the same side as the magnetic detection unit 2, and a Cu layer is placed as the first metal material 3 on the opposite side of the magnetic detection unit 2 with the layer of the second metal material 4 interposed therebetween.

The vertical axis and horizontal axis of the graph in Fig. 5 indicate the same contents as in the graph in Fig. 2. This graph indicates that the delay of the output voltage from the current sensor 10 is the smallest in the case in which the bus bar 1 with an Al ratio of 100% is provided and that there is an inflection point of the phase characteristics at an Al ratio from 40% to 60%.

It can be said from the results indicated in Fig. 5 that, in the case in which the same side as the magnetic detection unit 2 is placed so as to face the surface 4S of the Al layer, which is used as the second metal material 4, the thickness T4, which is a dimension of the second metal material 4 in the Z direction, which is the lamination direction, is preferably larger than the thickness T3, which is a dimension of the first metal material 3, from the viewpoint of suppressing deterioration in the frequency characteristics of the bus bar 1, the deterioration being related to the delay of the output voltage from the current sensor 10, and achieving weight reduction. Also, in the case in which the thickness T1, which a dimension of the bus bar 1, formed from a laminate material, in the lamination direction is 100%, the thickness T4 of the second metal material 4 is more preferably 60% or more.

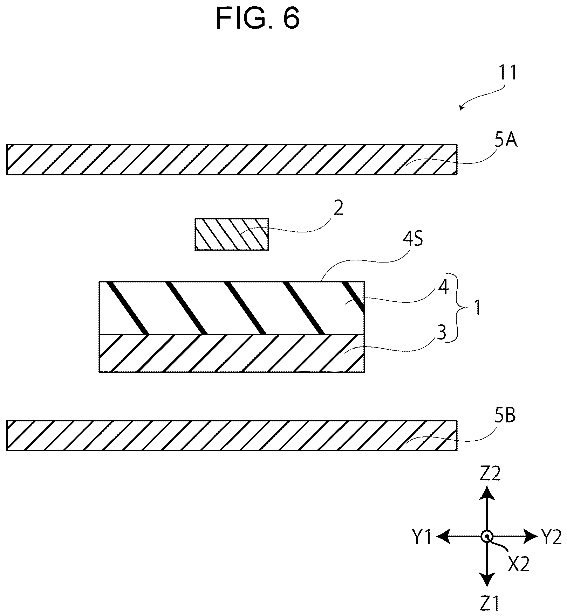

Fig. 6 is a sectional view of the current sensor 11 in which the magnetic shields 5A and 5B are provided. As indicated in the drawing, in the current sensor 11, the magnetic shields 5A and 5B may be provided on both sides in the Z direction so that the bus bar 1 and magnetic detection unit 2 are interposed therebetween. Due to the magnetic shields, it is possible to suppress magnetic noise from the outside into the magnetic detection unit 2, so measurement precision of the current sensor 10 is improved.

The current sensors, described above, in the first and second embodiments have a bus bar formed by laminating two types of metal materials. Thus, it is possible to achieve reduction in the amount of heat generation in the bus bar when a current under measurement flows and weight reduction of the bus bar, by adjusting the ratio of metal materials the densities and electrical resistivities of which differ.

### [Third embodiment]

In this embodiment, an aspect that practices the present invention as a current sensor of multi-phase type.

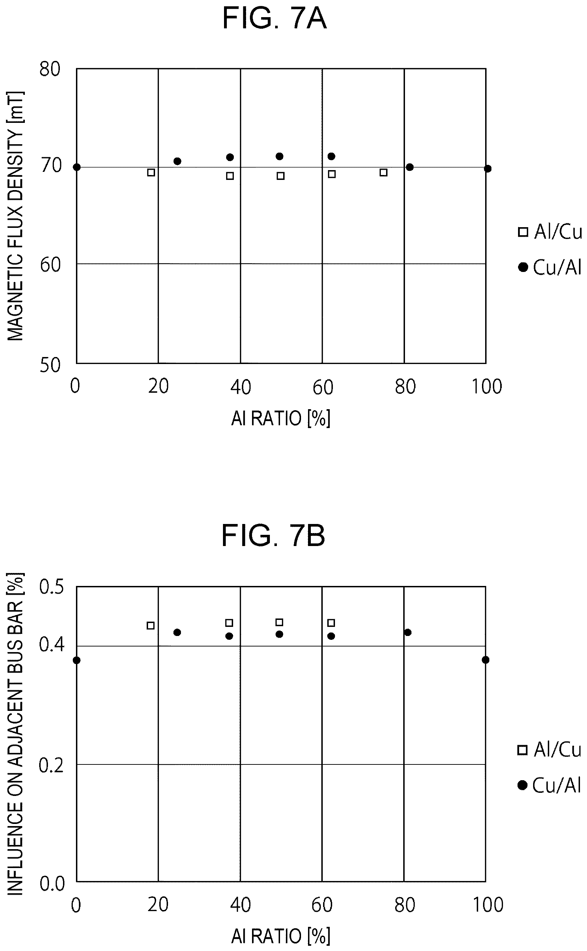

Fig. 7A is a graph of simulation results indicating differences in magnetic flux density in the vicinity of the bus bar 1 in the case in which in a current sensor of multi-phase type having a plurality of measurement phases, Cu is used as the first metal material 3 and Al is used as the second metal material 4, the differences being caused due to the lamination order of Al and Cu and an Al ratio. The Al ratio in the drawing indicates the same contents as in the simulation related to the frequency characteristics in the first and second embodiments.

Results indicated as Cu/Al are results of a simulation for the current sensor 10 (see Fig. 1), in which the magnetic detection unit 2 is provided on the surface 3S on the same side as Cu used as the first metal material 3.

Results indicated as Al/Cu are results of a simulation for the current sensor 11 (see Fig. 4), in which the magnetic detection unit 2 is provided on the surface 4S on the same side as Al used as the second metal material 4.

Incidentally, the simulation for Cu/Al and the simulation for Al/Cu were performed under the same conditions except the lamination order.

It was found that the magnetic flux density in the vicinity of the bus bar 1 varies as indicated in Fig. 7A, depending on which surface, the surface 3S on the Cu side or the surface 4S on the Al side, the magnetic detection unit 2 is provided on. It can be considered that the cause for these results is that when a current under measurement is caused to flow in the bus bar 1 formed from a laminate material formed from different types of metals, much more current flows on the Cu side, on which electrical resistivity is low, than on the Al side, on which electrical resistivity is high.

Also, it was found from the results indicated as Cu/Al that by using a laminate material, magnetic flux density becomes higher than in the case in which the bus bar 1 is formed from only Cu (Al ratio of 0%) and than in the case in which the bus bar 1 is formed from only Al (Al ratio of 100%). By forming the bus bar 1 from a laminate material in this way, magnetic flux density detected by the magnetic detection unit 2 becomes large and the measurement precision of the current sensor 10 is improved.

Fig. 7B is a graph indicating, in a current sensor of multi-phase type having a plurality of measurement phases, differences in the influence of the lamination order of Al and Cu and the Al ratio on an adjacent bus bar. The results indicated in the drawing indicate the magnitude of error caused in the current sensor at the center when three current sensors having bus bars formed from the same laminate material were arranged side by side and measurement was performed under the same condition. Also, Cu/Al and Al/Cu indicate a difference in the lamination order, which has been described for Fig. 7A, of the bus bar.

It was found from the results, indicated in Fig. 7B, for Cu/Al that by forming the bus bar from a laminate material in the case of a current sensor of multi-phase type, the bus bar is more greatly susceptible to the influence from an adjacent bus bar than in the case in which the bus bar is formed from only Cu (Al ratio of 0%) and than in the case in which the bus bar is formed from only Al (Al ratio of 100%). For this, it can be considered that by using, as a bus bar, a laminate material in which different types of metal materials are laminated, a difference in magnetic flux density in the Z direction in an induced magnetic field generated when a current under measurement flows became larger than in a bus bar for which a material of a single type of metal material was used.

Also, it was found from the results indicated in Fig. 7B, the influence from the adjacent bus bar is smaller in Cu/Al, in which the magnetic detection unit 2 was provided on the surface 3S on the Cu side than in Al/Cu, in which the magnetic detection unit 2 was provided on the surface 4S on the Al side. For this, it can be considered that in the bus bar 1, the current density of the current under measurement that flows on the same side as the first metal material 3, the electrical resistivity of which is low, became higher than the current density of the current under measurement that flows on the same side as the second metal material 4, the electrical resistivity of which is high, and thereby the magnetic flux density measured by the magnetic detection unit 2 became high.

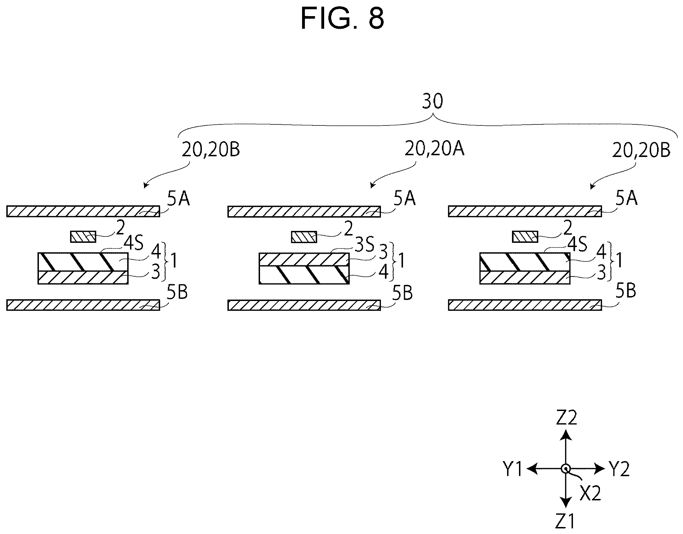

Fig. 8 is a sectional view indicating a current sensor 30 of multi-phase type in this embodiment.

As indicated in the drawing, the current sensor 30 has a plurality of measurement phases 20, each of which is composed of the bus bar 1, in which a current under measurement flows, as well as the magnetic detection unit 2 placed so as to face the bus bar 1, the magnetic detection unit 2 sensing a magnetic field generated around the bus bar 1.

The current sensor 30 has a first measurement phase 20A, in which the magnetic detection unit 2 is placed so as to face the surface 3S of the bus bar 1, the surface 3S being formed from the first metal material 3, and second measurement phases 20B, in each of which the magnetic detection unit 2 is placed so as to face the surface 4S of the bus bar 1, the surface 4S being formed from the second metal material 4.

Since the electrical resistivity of the first metal material 3 is smaller than that of the second metal material 4, much more current flows on the same side as the first metal material 3. Therefore, by placing the magnetic detection unit 2 so as to face the surface 3S formed from the first metal material 3, the magnetic field density of the induced magnetic field, sensed by the magnetic detection unit 2, of a current under measurement becomes large. Therefore, the sensing precision of the first measurement phase 20A becomes superior to that of the second measurement phases 20B.

For example, in the case in which there is a difference in sensing precision demanded for each measurement phase 20 in the current sensor 30 having a plurality of measurement phases 20, it is possible to select the first measurement phase 20A or second measurement phases 20B and place it, depending on necessary sensing precision.

In the current sensor 30 indicated in Fig. 8, three measurement phases 20 are placed side by side in the Y direction. Of the three measurement phases 20, the measurement phase 20 placed at the center receives influence from the measurement phases 20, to which the measurement phase 20 at the center is adjacent on both sides in the Y direction, so error of the measurement phase 20 becomes large. Thus, by using the first measurement phase 20A as the measurement phase 20 at the center and using the second measurement phases 20B as the measurement phases 20 on both sides, it is possible to suppress a drop in the sensing precision of the measurement phase 20 at the center and to reduce differences in measurement precision among a plurality of measurement phases 20.

Also, in all of the plurality of measurement phases 20 in the current sensor 30, the magnetic detection unit 2 is provided on the same side of the bus bar 1 (in Fig. 8, on the Z2 side). In this case, due to a structure in which second measurement phases 20B are adjacently placed on both sides of the first measurement phase 20A, the distance becomes large between the magnetic detection unit 2 in the first measurement phase 20A and the first metal material 3 of the bus bar 1 in the second measurement phase 20B on both sides. Also, since the current under measurement flowing in the bus bar 1 flows much more on the same side as the first metal material 3, the distance becomes large between a source from which an induced magnetic field is generated in the second measurement phase 20B placed on both sides of the first measurement phase 20A and the magnetic detection unit 2 in the first measurement phase 20A placed at the center. Therefore, it is possible to reduce the influence of a magnetic field from the bus bar 1 in the second measurement phases 20B, next to the first measurement phase 20A, on the first measurement phase 20A. Thus, as for the bus bar 1 in the measurement phases 20 adjacently placed on both sides of the first measurement phase 20A, the first metal material 3 is preferably laminated on the Z1 side, on which the distance from the magnetic detection unit 2 in the first measurement phase 20A is long.

With the current sensor 30, indicated in Fig. 8, which has a plurality of measurement phases 20, the thickness T4 of the second metal material 4 is preferably larger than the thickness T3 (see Fig. 1B and Fig. 4) of the first metal material 3 in the Z direction, which is the lamination direction of the first metal material 3 and second metal material 4, from the viewpoint of making frequency characteristics superior.

In the case in which the magnetic detection unit 2 faces the surface 3S formed from the first metal material 3, the thickness T4 of the second metal material 4 to the thickness of the bus bar 1 in the lamination direction is preferably larger than 50% and is more preferably 80% or more, as described in the first and second embodiments. Also, when the magnetic detection unit 2 faces the surface 4S formed from the second metal material 4, the thickness T4 of the second metal material 4 to the thickness of the bus bar 1 in the lamination direction is preferably larger than 50% and is more preferably 60% or more, as described in the first and second embodiments.

As described above, a structure is taken in which, in the measurement phase 20 at the center of the three adjacent measurement phases 20, the measurement phase 20 at the center being likely to receive the influence of the induced magnetic field of the adjacent measurement phases 20, the first metal material 3 is placed on the same side as the magnetic detection unit 2 in the bus bar 1, and the second metal material 4 is placed on the same side as the magnetic detection unit 2 in the bus bars 1 on both sides. Due to this structure, it is possible to reduce the influence from the adjacent bus bars 1 on the magnetic detection unit 2 facing the bus bar 1 at the center.

Incidentally, as for a current sensor formed from two measurement phases 20 adjacent to each other, a structure corresponding to demanded precision can be taken by using, as the first measurement phase 20A, a measurement phase 20 for which relatively high precision is demanded and by using, as the second measurement phases 20B, a measurement phase 20 for which low precision is demanded.

### [Variations]

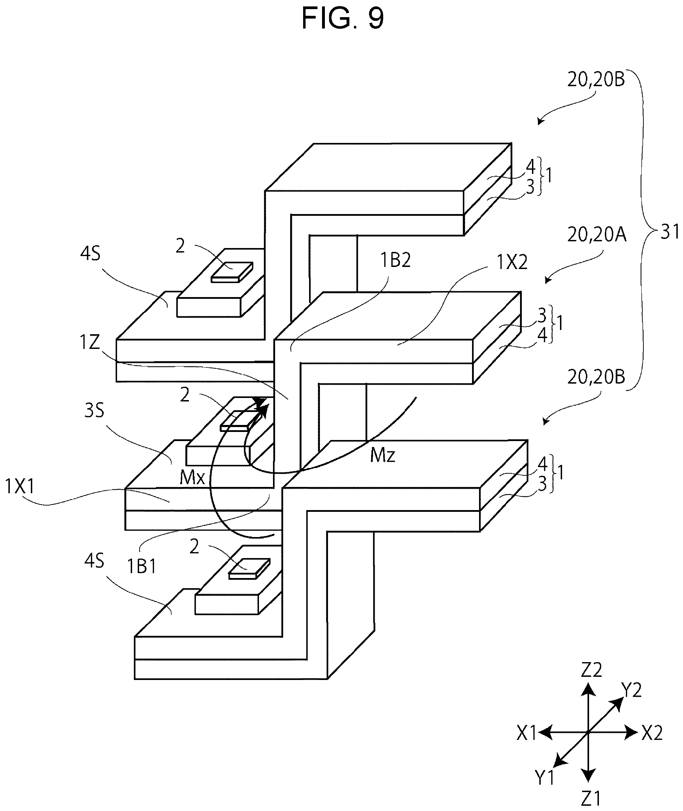

Fig. 9 a perspective view indicating a current sensor 31 of multi-phase type in a variation.

In the current sensor 31, the measurement phase 20 at the center of the three adjacent measurement phases 20 is the first measurement phase 20A and the measurement phases 20 on both sides are second measurement phases 20B. Also, the bus bar 1 has a first portion 1X1 and first portion 1X2, which extend in the X direction, as well as a second portion 1Z extending in the Z direction. The first portion 1X1 and second portion 1Z are connected together by a bent portion 1B1, and the first portion 1X2 and second portion 1Z are connected together by a bent portion 1B2. The bus bar 1 is structured in a crank shape in which the bent portion 1B1 and bent portion 1B2 are bent through 90 degrees in opposite directions when viewed from the Y direction.

The bus bar 1 in the first measurement phase 20A has the bent portion 1B2 on the Z2-direction side, the bent portion 1B2 being composed of the second portion 1Z and the first portion 1X2 extending from the Z2-direction end of the second portion 1Z toward the X2 side, as well as the bent portion 1B1 on the Z1-direction side, the bent portion 1B1 being composed of the second portion 1Z and the first portion 1X1 extending from the Z1-direction end of the second portion 1Z toward the X1 direction. At the bent portion 1B2 on the Z2-direction side, the second metal material 4 is inside the bent portion 1B2. At the bent portion 1B1 on the Z1-direction side, the first metal material 3 is inside the bent portion 1B1.

Incidentally, Fig. 9 showed the bus bar 1 that has two first portions, 1X1 and 1X2, and the second portion 1Z as well as the bent portion 1B1 and bent portion 1B2 at both ends of the second portion 1Z in the Z direction. However, a structure may be taken in which the first portion 1X1, second portion 1Z, and bent portion 1B1 are included or in which the first portion 1X2, second portion 1Z, and bent portion 1B2 are included. Also, although an aspect has been indicated in which all of the three measurement phases 20 have the bent portion 1B1 and bent portion 1B2, a structure may be taken in which one or two of the three measurement phases 20 have at least one of the bent portion 1B1 and bent portion 1B2. Incidentally, as for the bus bar 1 that has only the bent portion 1B1 or bent portion 1B2, the magnetic detection unit 2 is placed on the side on which the bent portion 1B1 or bent portion 1B2 is bent, that is, inside it.

The magnetic detection unit 2 is placed at a position at which the magnetic detection unit 2 can sense an induced magnetic field Mx from the first portion 1X1 continuous to the bent portion 1B1 and an induced magnetic field Mz from the second portion 1Z. In the bus bar 1, two portions between which the bent portion 1B1 is interposed are the first portion 1X1 and second portion 1Z, which are continuous to the bent portion 1B1.

Incidentally, the induced magnetic field Mx and induced magnetic field Mz in this variation are each an induced magnetic field including a Y-direction component. The magnetic detection unit 2 is placed so that the sensing direction of the magnetic detection unit 2 becomes parallel to the Y direction. That is, the magnetic detection unit 2 senses a combined component of the Y-direction component of the induced magnetic field Mx and the Y-direction component of the induced magnetic field Mz.

The position of the magnetic detection unit 2 is a position at which the induced magnetic field Mx and induced magnetic field Mz described above can be sensed. The magnitude of the combined component of the Y-direction component of the induced magnetic field Mx and the Y-direction component of the induced magnetic field Mz is preferably a magnitude that the magnetic detection unit 2 can easily sense. Due to this structure, it is possible to efficiently detect the induced magnetic field generated when a current under measurement flows in the bus bar 1 by use of the magnetic detection unit 2. Also, since the magnetic detection unit 2 in the first measurement phase 20A at the center is placed so as to face the surface 3S of the bus bar 1, the surface 3S being a layer of the first metal material 3, the magnetic flux density of a magnetic field is high, the magnetic field being generated when a current under measurement flows. Therefore, the magnetic sensing precision of the magnetic detection unit 2 becomes superior.

In the case in which the magnetic detection unit 2 is provided on the same side as the bus bar 1 in the Z direction, the distance between the magnetic detection unit 2 in the first measurement phase 20A and the first metal material 3 of the bus bar 1 in the second measurement phase 20B becomes long due to the structure in which the second measurement phases 20B are adjacently placed on both sides of the first measurement phase 20A. Thus, it is possible to reduce the influence of a magnetic field from the second measurement phases 20B on the first measurement phase 20A at the center. Since this effect is obtained at the first portion 1X1 and second portion 1Z, detection precision of the current sensor 31 is improved.

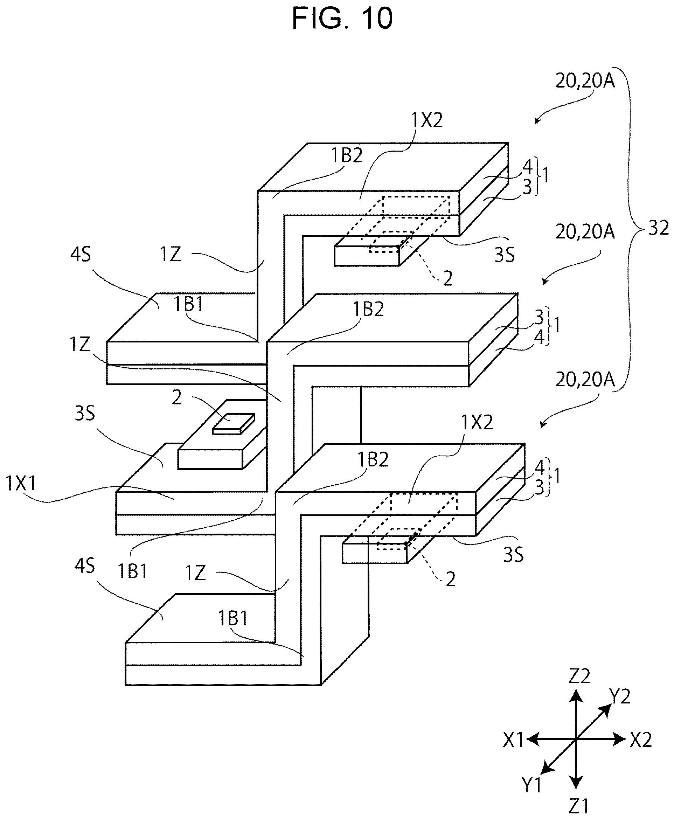

Fig. 10 is a perspective view indicating a current sensor 32 of multi-phase type in another variation. The current sensor 32 indicated in the drawing differs from the current sensor 31 in Fig. 9 in a structure in which in the measurement phases 20 on both sides, the magnetic detection unit 2 is placed inside the bent portion 1B2.

In the current sensor 32, the placement of the bus bars in the three measurement phases 20 placed side by side is the same as in the variation indicated in Fig. 9. As for the placement of the magnetic detection units 2, in the measurement phase 20 at the center, the magnetic detection unit 2 is placed so as to face the first portion 1X1 on the Z1 side and the surface 3S of the layer of the first metal material 3 of the second portion 1Z, as in the variation indicated in Fig. 9. In contrast to this, in the measurement phases 20 on both sides, the magnetic detection unit 2 is placed so as to face the first portion 1X2 of the bus bar 1 on the Z2 side and the surface 3S of the layer of the first metal material 3 of the second portion 1Z. That is, the magnetic detection unit 2 is placed so that all of the three measurement phases 20 placed side by side become the first measurement phase 20A. By placing the magnetic detection units 2 in the measurement phases 20 on both sides so as to face the surface 3S of the bus bar 1, the surface 3S being formed from the first metal material 3, in this way, the magnetic flux density detected by the magnetic detection unit 2 becomes large and the sensing precision of the measurement phase 20 is improved.

### [Reference example]

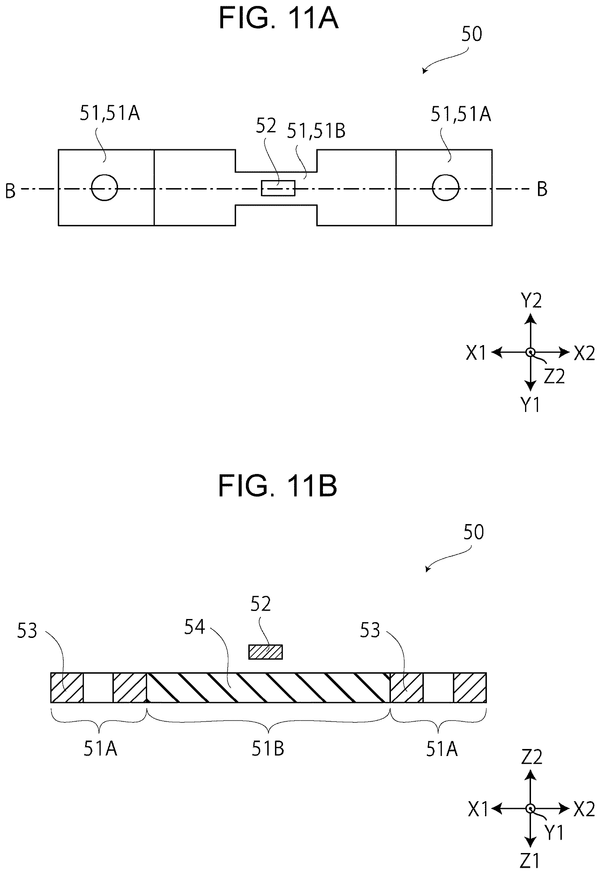

Fig. 11A is a plan view of a current sensor 50 in a reference example.

Fig. 11B is a sectional view of the current sensor 50 as taken along line BB in Fig. 11A.

As indicated in these drawings, in the current sensor 50, a magnetic detection unit 52 is placed so as to face a bus bar 51. With the bus bar 1 in the current sensor 50, tightening portions 51A and a main body 51B including a narrowly constricted portion facing the magnetic detection unit 52 are formed from different types of metal materials.

For example, the tightening portion 51A is Cu used as a first metal material 53, and the main body 51B is Al used as a second metal material 54. Due to this, it is possible to reduce the contact resistance of the tightening portion 51A and suppress heat generation by a current under measurement when compared with a case in which tightening portions 61A and main body 61B of the bus bar 61 in the conventional current sensor 60 indicated in Fig. 15C are formed from Al. Also, due to suppression of the skin effect in the bus bar 51, it is possible to improve the frequency characteristics of magnetic flux density detected by the magnetic detection unit 52.

Tables below indicate frequency characteristics (phase characteristics) of Cu and Al.

**[Table 1]**

| Table 1 | | Cu | Al |
|---|---|---|---|
| Phase angle, 1 KHz | deg | -0.64 | -0.43 |

**[Table 2]**

| Table 2 | Skin depth (mm) | |
|---|---|---|
| | Cu | Al |
| 1 KHz | 2.1 | 2.7 |

The skin depth in Table 2 is a distance over which a magnetic field that has entered a certain material is attenuated to 1/e (≒ 1/2.718 ≒ -8.7 db).

When a high-frequency current is caused to flow in a conductor, most of the current concentrates on a very narrow area near the surface of the conductor. This means that the resistance of the conductor is essentially increased at high frequencies and that although reduction in resistance is expected at low frequencies by thickening the conductor, effectiveness is not obtained at high frequencies. Therefore, it can be said that Al with a large skin depth is more preferable than Cu from the viewpoint of frequency characteristics.

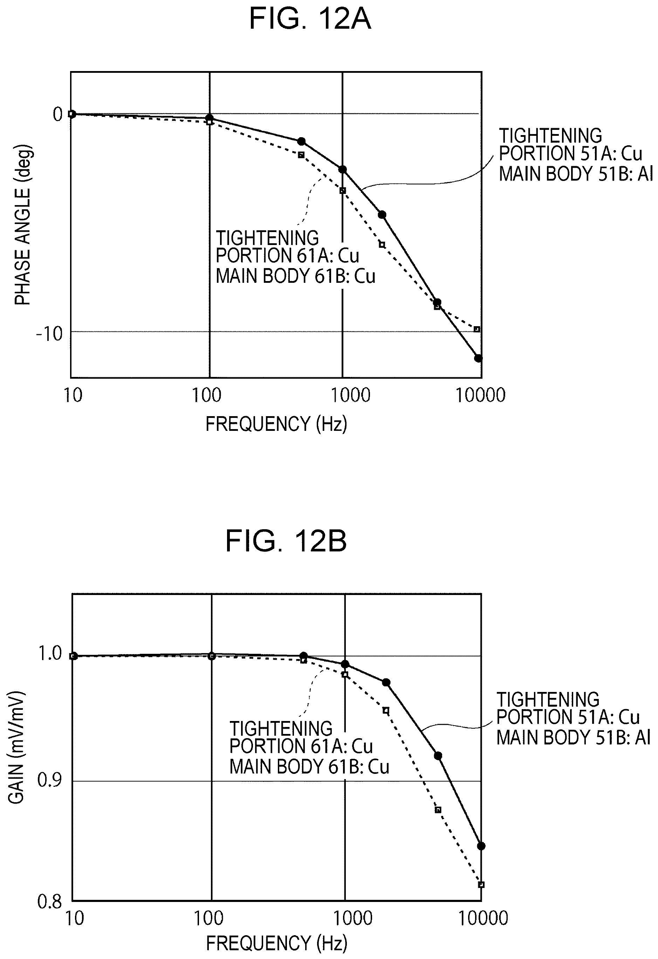

Fig. 12A is a graph indicating simulation results about the relationship between the frequency and phase angle of a current under measurement for the current sensor 50, in the reference example, having the bus bar 51, in which the tightening portion 51A is formed from Cu and the main body 51B is formed from Al and for the current sensor 60 having the bus bar 61 in which the tightening portion 61A and main body 61B are formed from Cu.

The graph in Fig. 12A represents a state in which the larger the value of the vertical axis (phase angle) is (the closer the value is to 0), the smaller the delay of the detection voltage with respect to the current under measurement is, that is, represents a superior state. It is found from this graph that even when the frequency of the current under measurement becomes high, the phase angle in the current sensor 50 is larger and the detection voltage is less delayed with respect to the current under measurement than in the current sensor 60.

Fig. 12B is a graph indicating simulation results about the relationship between the frequency and gain of a current under measurement for the current sensor 50, in the reference example indicated in Fig. 11A and Fig. 11B and for the current sensor 60 indicated in Fig. 15A to Fig. 15C.

The graph in Fig. 12B represents a state in which the larger the value (gain) of the vertical axis is (the closer the value is to 1), the more the detection voltage equivalent to the current under measurement is output, that is, represents a superior state. It is found from this graph that even when the frequency of the current under measurement becomes high, in the current sensor 50, the value of the vertical axis is larger and much more detection voltage equivalent to the current under measurement is output than in the current sensor 60.

It is found from the results in the graphs indicated in Fig. 12A and Fig. 12B that by changing the main body 61B of the bus bar 61 from Cu to Al, the delay of the detection voltage with respect to the current under measurement is reduced and the gain is improved.

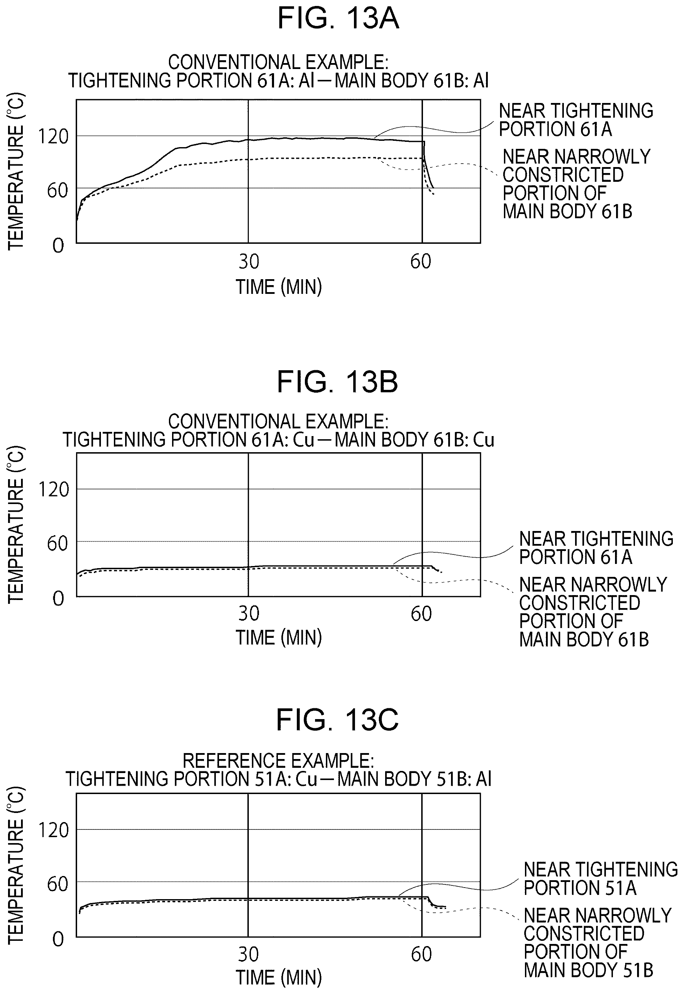

Fig. 13A is a graph indicating measurement results for temperature changes in the tightening portions 61A and the narrowly constricted portion of the main body 61B, the changes accompanying the elapse of time during which a current under measurement is caused to flow, for the current sensor 60 having the bus bar 61 in which the tightening portion 61A and main body 61B are formed from Al.

Fig. 13B is a graph indicating measurement results for temperature changes in the tightening portions 61A and the narrowly constricted portion of the main body 61B, the changes accompanying the elapse of time during which a current under measurement is caused to flow, for the current sensor 60 having the bus bar 61 in which the tightening portion 61A and main body 61B are formed from Cu.

Fig. 13C is a graph indicating measurement results for temperature changes in the tightening portions 51A and the narrowly constricted portion of the main body 51B, the changes accompanying the elapse of time during which a current under measurement is caused to flow when a current is caused to flow under the same conditions, for the current sensor 50, in the reference example, which has the bus bar 51 in which the tightening portion 51A is formed from Cu and the main body 51B is formed from Al.

It was found from the results indicated in Fig 13A to Fig. 13C that in the bus bar 61 formed from only Al, by causing a current under measurement to flow, temperature is more likely to rise than in the bus bar 61 formed from only Cu. However, in the bus bar 51 in which the tightening portion 51A is formed from Cu and the main body 51B is formed from Al, the temperature rise due to a flow of the current under measurement was suppressed as in the bus bar 61 in which both the tightening portion 51A and the narrowly constricted portion of the main body 51B are formed from only Cu.

Due to the comparison of the graphs in Fig. 13A to Fig. 13C, it is found that, in a state in which a current under measurement is caused to continuously flow, the temperature change at each portion varies depending on the difference in the material from which the tightening portion and main body are formed. In the bus bar 61, indicated in Fig. 13A, in which all are formed from Al, heat generation is very large when compared with the bus bar 61, indicated in Fig. 13B, in which all are formed from Cu. Just by forming the tightening portion from Cu with the main body left as being formed from Al, heat generation in the bus bar 51 was greatly suppressed as indicated in the graph in Fig. 13C. Incidentally, in each graph, a drop in temperature at the end after a duration of around 60 minutes is due to the stop of the current under measurement.

From these results, it can be said that the structure in which the tightening portion 51A is formed from Cu and the main body 51B is formed from Al is effective for reducing the delay of the detection voltage with respect to the current under measurement, improvement of gain, and suppression of a temperature rise when a current under measurement flows.

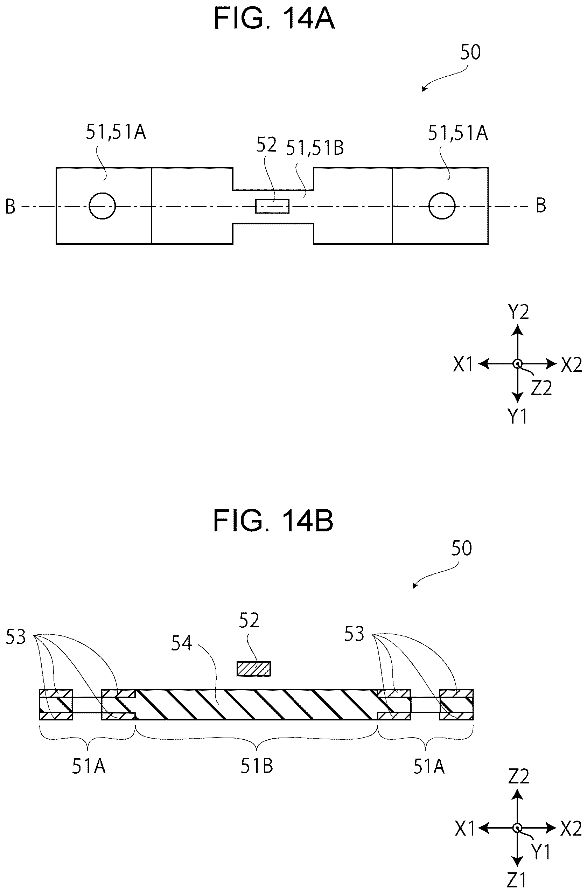

Fig. 14A is a plan view of the current sensor 50 in another reference example.

Fig. 14B is a sectional view of the current sensor 50 as taken along line BB in Fig. 14A.

As indicated in these drawings, even when a structure is taken in which the surface of Al of the tightening portion 51A of the bus bar 51 in the current sensor 50 in the Z-axis direction is covered with Cu, it is possible to suppress a temperature rise when a current under measurement flows.

The embodiments disclosed in this description are exemplary in all points. The present invention is not restricted to these embodiments. The scope of the present invention is not indicated by the description of only the embodiments described above but is indicated by the scope of the claims. It is intended that meanings equivalent to the scope of the claims and all modifications in the scope are included.

### Industrial Applicability

The present invention is useful as a current sensor that is attached to any of various units and measures a current under measurement to control and monitor the unit. Reference Signs List
- 1: bus bar
- 1B1: bent portion
- 1B2: bent portion
- 1X1: first portion
- 1X2: first portion
- 1Z: second portion
- 2: magnetic detection unit
- 3: first metal material
- 3S: surface
- 4: second metal material
- 4S: surface
- 5A: magnetic shield
- 5B: magnetic shield
- 10: current sensor
- 11: current sensor
- 20: measurement phase
- 20A: first measurement phase
- 20B: second measurement phases
- 30: current sensor
- 31: current sensor
- 32: current sensor
- 50: current sensor
- 51: bus bar
- 51A: tightening portion
- 51B: main body
- 52: magnetic detection unit
- 53: first metal material
- 54: second metal material
- 60: current sensor
- 61: bus bar
- 61A: tightening portion
- 61B: main body
- 62: magnetic detection unit
- Mx: induced magnetic field
- Mz: induced magnetic field
- T1: thickness
- T3: thickness
- T4: thickness

## Claims

1. A current sensor having a bus bar in which a current under measurement flows as well as a magnetic detection unit placed so as to face the bus bar, the magnetic detection unit sensing a magnetic field generated around the bus bar, the current sensor being **characterized in that**:
the bus bar is formed from a laminate material in which a first metal material and a second metal material, which are different types of metal materials, are laminated;
a density of the first metal material is larger than a density of the second metal material, and an electrical resistivity of the first metal material is smaller than an electrical resistivity of the second metal material; and
the magnetic detection unit is placed so as to face a surface of the bus bar, the surface being formed from the first metal material.

2. The current sensor according to Claim 1, wherein in a lamination direction, the dimension of the second metal material is larger than the dimension of the first metal material.

3. The current sensor according to Claim 1, wherein in a lamination direction, a dimension of the second metal material is 80% or more of a dimension of the lamination material.

4. A current sensor having a bus bar in which a current under measurement flows as well as a magnetic detection unit placed so as to face the bus bar, the magnetic detection unit sensing a magnetic field generated around the bus bar, the current sensor being **characterized in that**:
the bus bar is formed from a laminate material in which a first metal material and a second metal material, which are different types of metal materials, are laminated;
a density of the first metal material is larger than a density of the second metal material, and an electrical resistivity of the first metal material is smaller than an electrical resistivity of the second metal material; and
the magnetic detection unit is placed so as to face a surface of the bus bar, the surface being formed from the second metal material.

5. The current sensor according to Claim 4, wherein in a lamination direction, a dimension of the second metal material is larger than a dimension of the first metal material.

6. The current sensor according to Claim 4, wherein in a lamination direction, a dimension of the second metal material is 60% or more of a dimension of the lamination material.

7. A current sensor having a plurality of measurement phases, each of which is composed of a bus bar in which a current under measurement flows, as well as a magnetic detection unit placed so as to face the bus bar, the magnetic detection unit sensing a magnetic field generated around the bus bar, the current sensor being **characterized in that**:
the bus bar is formed from a laminate material in which a first metal material and a second metal material, which are different types of metal materials, are laminated;
a density of the first metal material is larger than a density of the second metal material, and an electrical resistivity of the first metal material is smaller than an electrical resistivity of the second metal material; and
a first measurement phase is provided in which the magnetic detection unit is placed so as to face a surface of the bus bar, the surface being formed from the first metal material, and a second measurement phase is provided in which the magnetic detection unit is placed so as to face a surface of the bus bar, the surface being formed from the second metal material.

8. The current sensor according to Claim 7, wherein second measurement phases are adjacently placed on both sides of the first measurement phase.

9. The current sensor according to Claim 7, wherein in a lamination direction, a dimension of the second metal material is larger than a dimension of the first metal material.

10. The current sensor according to Claim 7, wherein:
in at least one measurement phase, the bus bar has a bent portion; and
the magnetic detection unit is placed at a position at which the magnetic detection unit is capable of sensing induced magnetic fields from two portions positioned with the bent portion interposed between the two portions in the bus bar.

11. The current sensor according to Claim 10, wherein:
in the bus bar, the first metal material is provided on a side on which the bent portion is bent; and
the magnetic detection unit faces a layer of the first metal material of the bus bar.

12. The current sensor according to Claim 1, 4, or 7, wherein:
the first metal material is a copper material; and
the second metal material is an aluminum material.
